# EUROPÄISCHE PATENTSCHRIFT

(11) **EP 0 455 653 B1**
(45) Veröffentlichungstag und Bekanntmachung des Hinweises auf die Patenterteilung: **05.05.1993**
(21) Anmeldenummer: 90901746.9
(22) Anmeldetag: 22.01.1990
(51) Int. Cl.: G11C 29/00

(54) **INTEGRIERTER HALBLEITERSPEICHER**
INTEGRATED SEMICONDUCTOR STORE
MEMOIRE SEMICONDUCTRICE INTEGREE

(30) Priorität: 26.01.1989 WO PCT/DE89/00045; 26.06.1989 DE 3920871
(43) Veröffentlichungstag der Anmeldung: 13.11.1991
(73) Patentinhaber: SIEMENS AKTIENGESELLSCHAFT, 80333 München (DE)
(72) Erfinder: HOFFMANN, Kurt, Prof., D-8028 Taufkirchen (DE); LUSTIG, Bernhard, Dr., D-8000 München 83 (DE); KOWARIK, Oskar, Dr., D-8018 Grafing (DE); KRAUS, Rainer, Dipl.-Phys., D-8000 München 83 (DE); OBERLE, Hans-Dieter, D-8031 Puchheim (DE)
(86) Internationale Anmeldenummer: DE9000036
(87) Internationale Veröffentlichungsnummer: WO9009024

(56) Entgegenhaltungen:
- EP-A- 0 283 907
- EP-A- 0 286 852
- US-A- 4 393 475
- US-A- 4 744 061

## Beschreibung

Die Erfindung betrifft einen integrierten Halbleiterspeicher nach dem Oberbegriff des Patentanspruches 1.

Moderne integrierte Halbleiterspeicher enthalten sehr viele Speicherzellen. Beispielsweise weisen moderne DRAM's eine Speicherkapazität von 4 oder 16 MBit auf. Die Prüfzeit üblicher Funktionstests steigt bekanntlich mindestens doppelt linear mit einer zunehmenden Anzahl von Speicherzellen an. Viele Prüfmuster bewirken sogar eine quadratische Zunahme der Prüfzeit bei zunehmender Speicherkapazität. Aus diesem Grunde ist man schon seit einiger Zeit bemüht, im Halbleiterspeicher selbst Einrichtungen vorzusehen, die es ermöglichen, die Prüfzeit zu verkürzen. Dies läßt sich beispielsweise dadurch erreichen, daß mehrere (im Normalbetrieb unabhängig voneinander betriebene) Speicherzellen im Testbetrieb parallel zueinander betrieben werden, das Testergebnis speicherintern ermittelt wird und letztendlich als Fehlersignal am üblichen Datenausgangsanschluß zur Verfügung steht.

Eine gattungsgemäße Schaltungsanordnung ist beispielsweise aus der EP-A 0 283 907 bekannt. Sie ermöglicht ein gleichzeitiges Auslesen von (Test-)Daten aus allen entlang einer Wortleitung angeordneten Speicherzellen. Ein solcher Speicher läßt sich also zeilenweise parallel testen. Nachteilig bei dieser bekannten Schaltungsanordnung sind zwei Punkte: Zum einen ist für den Testbetrieb zur Ansteuerung der Trenntransistoren ein Potential bereitzustellen, das wertemäßig zwischen den beiden üblichen Versorgungspotentialen des Halbleiterspeichers liegt. Dies erfordert eine eigenständige Potentialerzeugung auf dem Halbleiterchip selbst. Zum anderen kann es im Testbetrieb geschehen, daß bei Auftreten eines Fehlers in einer Speicherzelle an einer einzelnen Wortleitung die dieser Speicherzelle zugeordnete interne Bewerterschaltung nach zunächst richtig erfolgter Bewertung fälschlicherweise in eine Lage kippt, die anzeigt, daß die (in Wirklichkeit defekte) Speicherzelle in Ordnung sei. Dies kann beispielsweise bei ungünstiger Dimensionierung des Potentials am Gate der Trenntransistoren dadurch geschehen, daß aufgrund der aus den übrigen Speicherzellen derselben Wortleitung ausgelesenen (richtigen) Daten, die ja als elektrisches Potential über deren interne Bitleitungen an die externe Bitleitung gelangen und somit auch an die mit der defekten Speicherzelle verbundene Bitleitung, diese Bitleitung auf ein Potential gezogen bzw. gedrückt wird, das die interne Bewerterschaltung zum Kippen bringt. Die interne Bewerterschaltung kippt somit vom ursprünglich richtigerweise den Defekt der Speicherzelle anzeigenden Zustand über in einen Zustand, der zur Anzeige des "Gut"-Falles gedacht ist.

Aufgabe der vorliegenden Erfindung ist es, einen gattungsgemäßen Halbleiterspeicher so weiterzubilden, daß der vorgenannte Fehler nicht auftreten kann.

Diese Aufgabe wird gelöst durch die kennzeichnenden Merkmale des Patentanspruches 1. Vorteilhafte Aus- und Weiterbildungen sind in Unteransprüchen gekennzeichnet.

Die Erfindung wird im folgenden anhand der Figuren näher erläutert. Es zeigen
die FIG 1 bis 4 vorteilhafte Ausgestaltungen der Erfindung,
die FIG 5 und 6 vorteilhafte Einzelheiten der Erfindung.

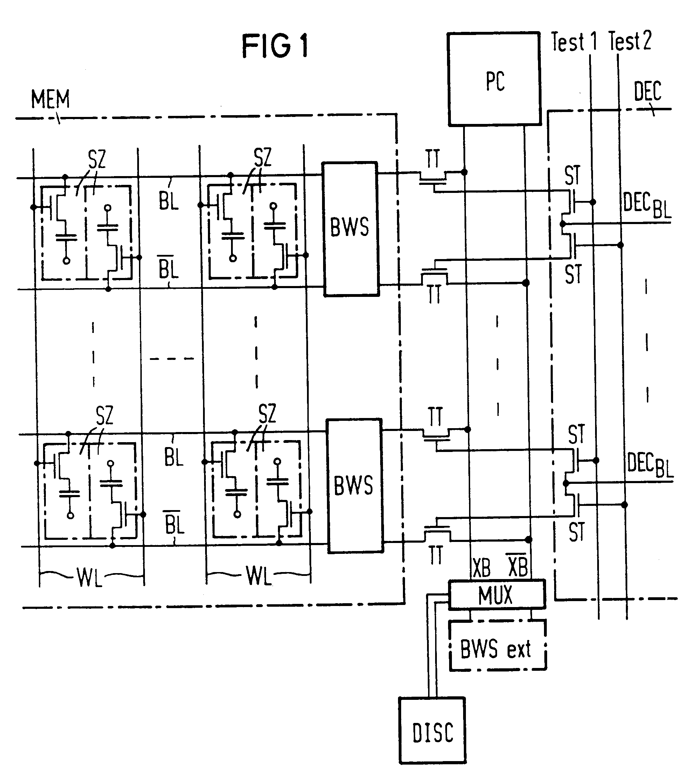

FIG 1 zeigt ein Speicherzellenfeld MEM mit Speicherzellen SZ, Paare von internen Bitleitungen BL,B̅L̅, Wortleitungen WL und interne Bewerterschaltungen BWS. Aus Gründen der Übersichtlichkeit sind nur wenige dieser Elemente dargestellt. Wie üblich, sind je eine interne Bitleitung BL und eine interne Bitleitung B̅L̅unter Bildung eines Paares von internen Bitleitungen BL,B̅L̅ an eine interne Bewerterschaltung BWS angeschlossen. Zwischen jedem Paar von internen Bitleitungen BL,B̅L̅ samt zugehöriger interner Bewerterschaltung BWS einerseits und einem Paar externer Bitleitungen XB,X̅B̅ andererseits ist ein Paar von Trenntransistoren TT angeordnet. Jedes Paar von Trenntransistoren TT ist gatemäßig mit einem Bitleitungsdekoder DEC verbunden. Beim Stande der Technik nach EP-A 0 283 907 (deren Offenbarung Bestandteil dieser Beschreibung ist, soweit mit der vorliegenden Erfindung vereinbar) sind die Gates jedes Paares von Trenntransistoren TT gemeinsan mit dem Bitleitungsdekoder DEC verbunden. Dabei dient jedes Paar von Trenntransistoren TT dazu, das ihm zugeordnete Paar von internen Bitleitungen BL,B̅L̅ in Abhängigkeit vom jeweiligen Ausgang des Bitleitungsdekoders DEC an das Paar externer Bitleitungen XB,X̅B̅ anzukoppeln oder abzukoppeln, was gleichbedeutend ist mit "Auswählen eines Paares von internen Bitleitungen BL,B̅L̅". Das Paar der externen Bitleitungen XB,X̅B̅ ist mit einer externen Bewerterschaltung BWSext verbunden.

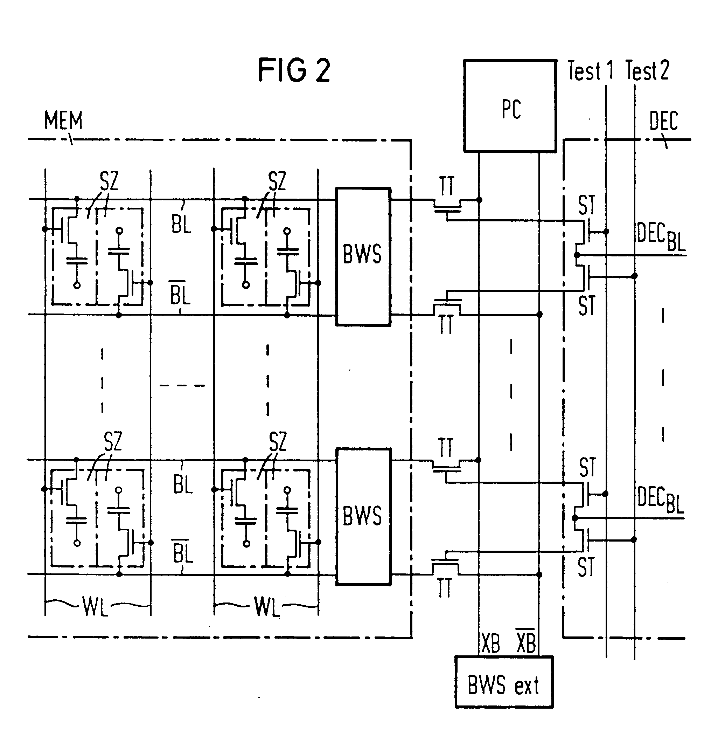

In ersten Ausführungsformen der Erfindung, dargestellt in den Figuren 1 und 2, sind die Trenntransistoren TT jeden Paares von Trenntransistoren TT in einem Testbetrieb getrennt voneinander über ihre Gates ansteuerbar. Damit ist im Testbetrieb entweder die eine interne Bitleitung BL eines Paares interner Bitleitungen BL,B̅L̅ ansteuerbar oder die andere interne Bitleitung B̅L̅, was eine Verbindung entweder mit der einen externen Bitleitung XB oder mit der anderen externen Bitleitung X̅B̅ der Paares externer Bitleitungen XB,X̅B̅ ergibt. Weist beispielsweise der Bitleitungsdekoder DEC eine Vorrichtung auf, die es ermöglicht, im Testfall die einen (bzw. die anderen) Trenntransistoren TT mehrerer bis aller Paare vor Trenntransistoren TT anzusteuern (entsprechende Dekoder sind beispielsweise aus den anmeldereigenen Offenlegungsschriften EP-A 0 282 975 und EP-A 0 283 908 bekannt), lassen sich über die einen internen Bitleitungen BL (bzw. über die anderen internen Bitleitungen B̅L̅) prinzipiell diejenigen Informationen parallel zueinander auf die eine externe Bitleitung XB (bzw. auf die andere externe Bitleitung X̅B̅) auslesen, die in vielen bis allen Speicherzellen SZ entlang einer Wortleitung WL gespeichert sind. Zur getrennten Ansteuerung der Trenntransistoren TT ist je Paar von Trenntransistoren TT beispielsweise ein Paar von Schalttransistoren ST vorgesehen, die die Gates der Trenntransistoren TT ansteuern.

Bevor einzelne vorteilhafte Ausführungsformen näher erläutert werden, wird nachstehend die Funktionsweise näher beschrieben: Sind im Testfall mehrere bis alle an einer ausgewählten Wortleitung WL angeordnete Speicherzellen SZ parallel zueinander zu testen, so werden die in allen Speicheriellen SZ entlang dieser Wortleitung WL gespeicherten Informationen (= Daten) gleichzeitig aus allen Speicherzellen SZ auf die mit den Speicherzellen SZ verbundenen einen internen Bitleitungen BL (bzw. anderen internen Bitleitungen B̅L̅, abhängig davon, ob die betroffenen Speicherzellen SZ mit den einen internen Bitleitungen BL oder mit den anderen internen Bitleitungen B̅L̅ verbunden sind) ausgelesen. Anschließend daran werden die ausgelesenen Daten in den internen Bewerterschaltungen BWS bewertet und verstärkt. Durch die Bewertung kippen die Bewerterschaltungen BWS in einen dem zu bewertenden Datum entsprechenden Zustand, wie allgemein bekannt.

Wurde, wie im Beispiel angenommen, eine Wortleitung WL zum Auslesen der Daten aus Speicherzellen SZ angesteuert, deren zugeordnete Speicherzellen SZ mit den einen internen Bitleitungen BL verbunden sind, so weist nach dem Bewerten im Gut-Fall also jede der einen internen Bitleitungen BL das ausgelesene Datum (beispielsweise "log. 1", wie für die weitere Beschreibung angenommen) auf. Entsprechend weisen die anderen internen Bitleitungen B̅L̅ ein dazu komplementäres Datum (im Beispiel: "log. 0") auf. Spätestens zu diesem Zeitpunkt wird die eine externe Bitleitung XB des externen Bitleitungspaares XB,X̅B̅ auf der im Gut-Fall eine log. 1 erwartet wird, auf log. 1 vorgeladen. Die jeweils andere externe Bitleitung X̅B̅ kann auf log. 0 vorgeladen werden. Dies ist jedoch nicht notwendig, wie nachstehend noch erläutert wird. Nun wird für jedes Paar der internen Bitleitungen BL,B̅L̅, bei dem eine Speicherzelle auszulesen war, der eine Trenntransistor TT durchgeschaltet. Im Gut-Fall behält die eine, demzufolge die auf log. 1 vorgeladene, externe Bitleitung XB des externen Bitleitungspaares XB, X̅B̅, ähnlich wie bereits in EP-A 0 283 907 beschrieben, ihren durch Vorladen entstandenen Zustand bei. Im Fehlerfall (d.h. mindestens eine der eine internen Bitleitungen BL weist das Datum log. 0 auf) sinkt das Potential der einen, ursprünglich auf log. 1 vorgeladenen externen Bitleitung XB um einen Betrag ΔU_{ERROR} soweit ab, bis sich über die restlichen einen internen Bitleitungen BL, die den richtigen Wert log. 1 aufweisen, ein Gleichgewicht einstellt. Die externe Bewerterschaltung BWSext ist während dieses Vorganges deaktiviert. Eine Diskriminatoreinrichtung DISC erkennt dieses Absinken und gibt entsprechend ein Fehlersignal ab. Die Wirkung der Erfindung ist somit, soweit bislang beschrieben, ähnlich der aus EP-A 0 283 907 bekannten Wirkung. Zusätzlich dazu verhindert jedoch die vorliegende Erfindung ein Kippen derjenigen internen Bewerterschaltung BWS, an deren zugeordneten Speicherzelle SZ oder an deren zugeordnetem internen Bitleitungspaar BL,B̅L̅ der Fehler auftrat, in einen Zustand, der (irrtümlicherweise) dem Zustand entspricht, der im Gut-Fall vorliegen würde. Dieses Kippen wird bei einer Anordnung, bei der die Bitleitungen BL, B̅L̅ eines Paares von internen Bitleitungen BL, B̅L̅ jeweils gleichzeitig mit dem externen Bitleitungspaar XB, X̅B̅ verbunden sind, d.h. bei einer Anordnung nach dem vorbekannten Stande der Technik, durch die andere externe Bitleitung X̅B̅ verursacht. Beim vorbekannten Stande der Technik weist diese den Zustand log. 0 auf, wodurch bei gleichzeitigem Verbinden der Bitleitungen BL, B̅L̅ eines Paares von internen Bitleitungen BL, B̅L̅ diejenige andere interne Bitleitung B̅L̅, die fehlerbedingt auf log. 1 liegt, auf log. 0 gezogen wird. Dies löst jedoch das Kippen der internen Bewerterschaltung BWS aus. Die erfindungsgemäße getrennte Verbindbarkeit der Bitleitungen BL, B̅L̅ jedes Paares der internen Bitleitungen BL, B̅L̅ mit dem externen Bitleitungspaar XB, X̅B̅, beispielsweise realisiert durch getrennte Ansteuerung der Trenntransistoren TT je Paar von Trenntransistoren TT verhindert dies jedoch zuverlässig, da jeweils der andere Trenntransistor TT gesperrt ist. Das Sperren des anderen Trenntransistors TT jeden Paares von Trenntransistoren TT wiederum ist der Grund, weshalb es nicht notwendig ist, die andere externe Billeitung X̅B̅ auf log. 0 vorzuladen.

Von einer detaillierten Beschreibung von Funktion und Betriebsverfahren der vorliegenden Erfindung für den Fall, daß Speicherzellen SZ zu testen sind, die jeweils mit der anderen internen Bitleitung B̅L̅ verbunden sind, wird abgesehen, da der Fachmann leicht erkennt, daß obige Ausführungen auch für diesen Fall sinngemäß gelten, wenn er die Nomenklatur entsprechend ändert (z.B. Ersetzen von "die eine interne Bitleitung BL" durch "die andere interne Bitleitung B̅L̅", "die eine externe Bitleitung XB" durch "die andere externe Bitleitung X̅B̅", "der eine Trenntransistor TT der Paare von Trenntransistoren TT" durch "der andere Trenntransistor TT der Paare von Trenntransistoren TT" und umgekehrt).

In dem Fall, in dem die zu testenden Speicherzellen SZ log. 0 enthalten sollen, wird, ebenso wie bereits in EP-A 0 283 907 beschrieben, der Effekt ausgenutzt, daß sich bei jedem internen Bitleitungspaar BL,B̅L̅ auf derjenigen internen Bitleitung, die nicht mit der zu testenden jeweiligen Speicherzelle SZ verbunden ist, ein zum ausgelesenen und verstärkten Lesesignal komplementäres Signal, d.h. also im Gut-Fall eine log. 1 ausbildet. Demzufolge wird in diesem Fall die andere externe Bitleitung X̅B̅ auf log. 1. vorgeladen. Außerdem werden die anderen internen Bitleitungen B̅L̅ über den jeweiligen anderen Trenntransistor TT mit der anderen externen Bitleitung X̅B̅ elektrisch leitend verbunden, während die einen Trenntransistoren TT gesperrt bleiben.

Anhand der vorhergehenden Ausführungen, einen Test auf log. 1 betreffend, kann nun der Fachmann selbst nachvollziehen, daß im Gut-Fall die andere externe Bitleitung X̅B̅ ihren Wert log. 1 beibehält und demzufolge die Diskriminatoreinrichtung kein Fehlersignal erzeugt und daß im Fehler-Fall die andere externe Bitleitung X̅B̅ potentialmäßig um den bereits beschriebenen Betrag ΔU_{ERROR} in Richtung log. 0 gezogen wird. Dies wiederum erkennt die Diskriminatoreinrichtung DISC und aktiviert entsprechend das Fehlersignal. Ein Kippen der betroffenen internen Bewerterschaltung BWS ist auch in diesem Fall zuverlässig ausgeschlossen. Wegen der Analogie zum bereits beschriebenen Testen auf log. 1 wird von einer ausführlichen Erläuterung abgesehen.

Nachstehend werden nun einzelne vorteilhafte Ausgestaltungen der Erfindung näher beschrieben: Die getrennte Ansteuerung der Bitleitungen BL, B̅L̅ je Paar der internen Bitleitungen BL, B̅L̅ mittels der Trenntransistoren TT erfolgt nach den FIG 1 und 2 vorteilhafterweise durch den Bitleitungsdekoder DEC unter Verwendung eines Paares von Testsignalen Test1, Test2 und (je Paar interner Bitleitungen BL,B̅L̅) eines Paares von Schalttransistoren ST. Anstelle der Schalttransistoren ST sind auch Transfergates aus parallelgeschalteten p- und n-Kanal-Transistoren mit entsprechend zueinander komplementärer Ansteuerung verwendbar. Bei der in den FIG 1 und 2 gezeigten Verwendung von Schalttransistoren ST ist bei jedem (nach dem Stande der Technik üblichen, eigentlichen) Dekoderausgang DEC_{BL} des Bitleitungsdekoders DEC eine Serienschaltung des Paares von Schalttransistoren ST vorgesehen. Deren Sources sind gemeinsam mit dem eigentlichen Dekoderausgang DEC_{BL} verbunden. Ihre Drains sind mit den Gates des einen bzw. des anderen Trenntransistors TT verbunden. Sie bilden nunmehr die Ausgänge des so modifizierten Bitleitungsdekoders DEC. Das Gate des einen Schalttransistors ST ist mit dem einen Testsignal Test1 verbunden. Das Gate des anderen Schalttransistors ST ist mit dem anderen Testsignal Test2 verbunden. Somit sind im Testbetrieb stets einer der Schalttransistoren ST der Paare von Schalttransistoren ST sperrbar und einer ist elektrisch leitend schaltbar. Damit ist sichergestellt, daß im Testbetrieb nie beide Trenntransistoren TT des zugehörigen Paares von Trenntransistoren TT leitend sind. In einem üblichen Normalbetrieb hingegen
sind alle Schalttransistoren ST elektrisch leitend schaltbar, so daß der Normalbetrieb gegenüber einem Halbleiterspeicher nach dem vorbekannten Stand der Technik nicht eingeschränkt ist.

Die Schalttransistoren ST weisen, wie leicht einsehbar, einen gewissen zusätzlichen Flächenbedarf beim integrierten Halbleiterspeicher auf. Wendet man die vorliegende Erfindung jedoch auf einen integrierten Halbleiterspeicher an, der sogenannte "shared bit decoder" enthält (dabei ist das Speicherzellenfeld MEM in mehrere Blöcke eingeteilt, die parallel zueinander über einen einzigen Bitleitungsdekoder angesteuert werden), so wird der zusätzliche Flächenbedarf nur für diesen einzigen Bitleitungsdekoder benötigt und nicht für alle Blöcke des Speicherzellenfeldes MEM. Der zusätzliche Flächenbedarf ist somit minimal bezüglich des Flächenbedarfes des gesamten integrierten Halbleiterspeichers.

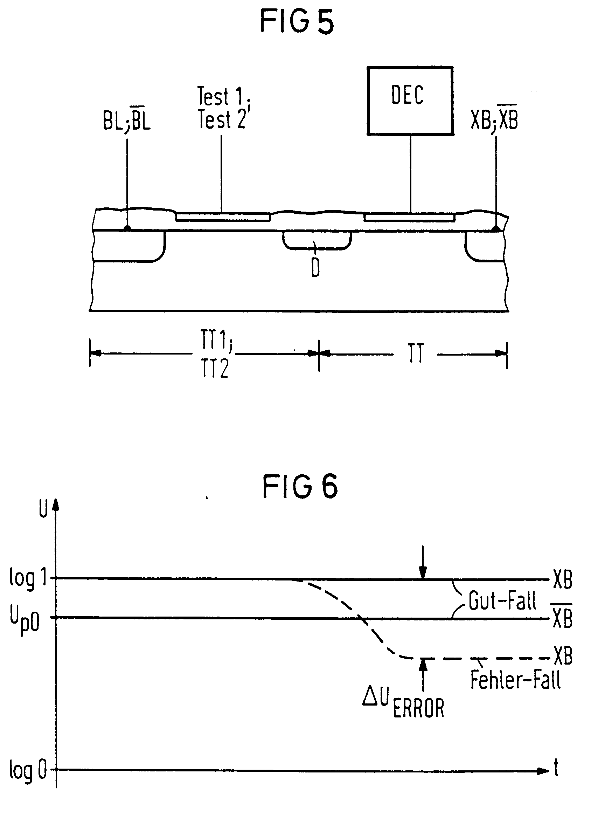

Lädt man, wie in FIG 6 gezeigt, gemäß einer weiteren vorteilhaften Auspestaltung der Erfindung die andere externe Bitleitung X̅B̅ (bzw. XB) des externen Bitleitungspaares XB,X̅B̅, deren Vorladen auf log. 0 gemäß den vorstehenden Ausführungen nicht notwendig ist, zu den genannten Testzwecken jedoch auf ein Potential Uₚ₀ vor, das um den halben Wert ΔU_{ERROR} unter dem Wert von log. 1 liegt, um den im Fehlerfall, wie bereits beschrieben, die eine auf log. 1 vorgeladene externe Bitleitung XB (bzw. X̅B̅) absinkt, und aktiviert die externe Bewerterschaltung BWSext, so wirkt diese selbst als Diskriminatoreinrichtung DISC und kippt in eine Lage, die dem Fehlerfall entspricht, wodurch ihr Ausgang als Fehlersignal wirkt. Damit läßt sich eine separate Diskriminatoreinrichtung DISC samt einer evtl. notwendigen Multiplexschaltung MUX, wie in FIG 1 und bei EP-A 0 283 907 dargestellt, einsparen. Dies ist in FIG 2 gezeigt.

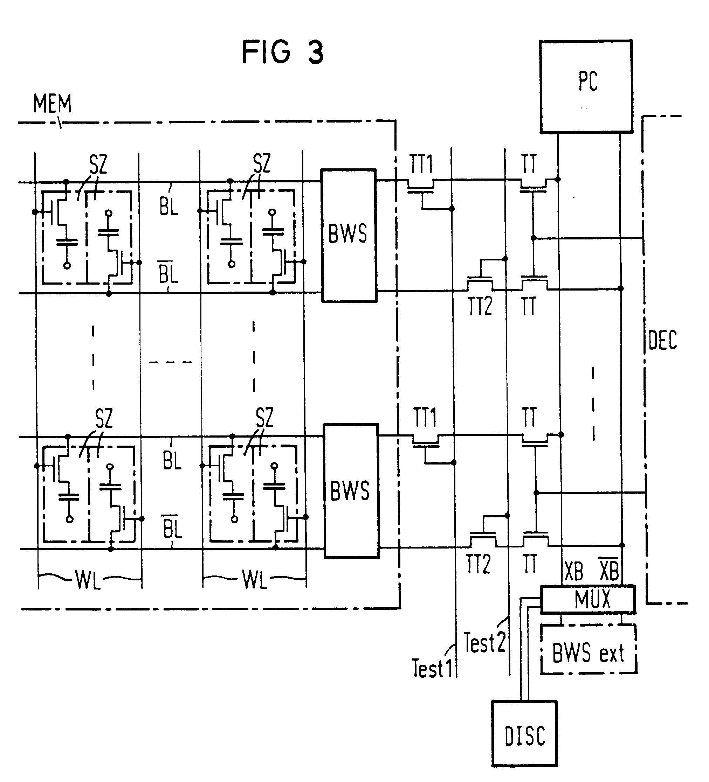

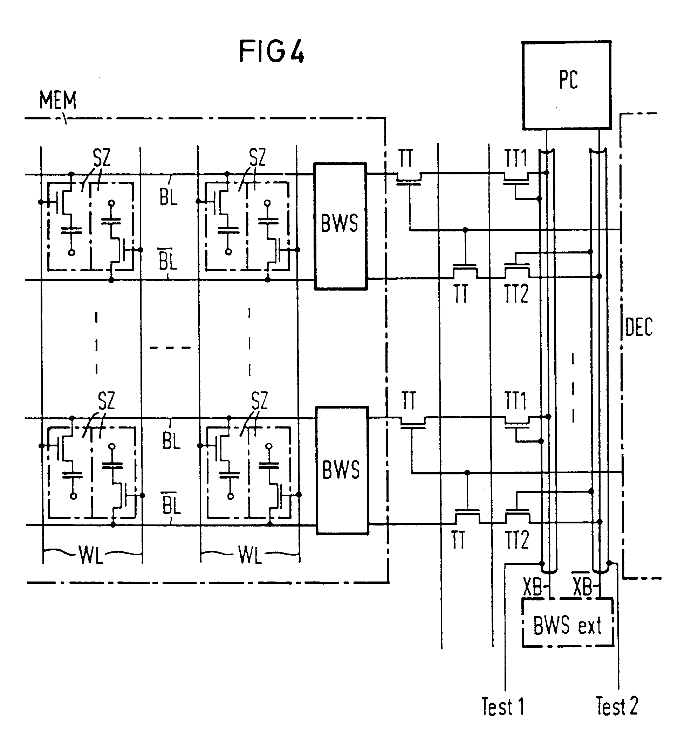

In zweiten Ausführungsformen, dargestellt in den Figuren 3 und 4, ist jedes Paar von Trenntransistoren TT gemeinsam gatemäßig mit einem Ausgang des Dekoders DEC verbunden. Die Paare von Trenntransistoren TT sind demzufolge parallel zueinander über ihre Gates ansteuerbar. Dazu weist beispielsweise der Dekoder DEC eine Vorrichtung auf, die es ermöglicht, im Testfall mehrere bis alle Paare von Trenntransistoren TT parallel anzusteuern. Entsprechende Dekoder sind, wie bereits erwähnt, beispielsweise aus den anmeldereigenen Offenlegungsschriften EP-A-0 282 975 und EP-A-0 283 908 bekannt. Damit lassen sich prinzipiell die Informationen parallel zueinander auslesen, die in vielen bis allen Speicherzellen SZ entlang einer Wortleitung WL gespeichert sind. Erfindungsgemäß ist zur getrennten Ansteuerung der Bitleitungen BL, B̅L̅ jedes internen Paares von Bitleitungen BL,B̅L̅ im Testbetrieb je Paar von Trenntransistoren TT ein weiteres Paar von Trenntransistoren TT1, TT2 vorgesehen, dessen Transistoren TT1, TT2 in Serie zum jeweiligen Trenntransistor TT des einen Paares von Trenntransistoren TT geschaltet sind. Die Gates der einen Transistoren TT1 der weiteren Paare von Trenntransistoren TT1, TT2 sind im Betrieb durch ein erstes Testsignal Test1 gesteuert. Die Gates der anderen Transistoren TT2 des weiteren Paares von Trenntransistoren TT1, TT2 sind im Betrieb durch ein zweites Testsignal Test2 gesteuert. Im Normalbetrieb weisen beide Testsignale Test1, Test2 ein Potential auf, bei dem die weiteren Paare von Trenntransistoren TT1, TT2 durchgeschaltet sind (bei n-Kanal-Ausführung der Trenntransistoren TT1, TT2 beispielsweise das übliche Versorgungspotential VDD).

Wenn nun im Testfall mehrere bis alle an einer ausgewählten Wortleitung WL angeordnete Speicherzellen SZ parallel zueinander zu testen sind, so werden die in allen Speicherzellen SZ entlang dieser Wortleitung WL gespeicherten Informationen (= Daten) gleichzeitig aus allen Speicherzellen SZ auf die mit den Speicherzellen SZ verbundenen internen Bitleitungen BL (bzw. B̅L̅, abhängig davon, ob die betroffenen Speicherzellen SZ mit den Bitleitungen BL oder mit den Bitleitungen B̅L̅ verbunden sind) ausgelesen. Anschließend daran werden die ausgelesenen Daten in den internen Bewerterschaltungen BWS bewertet und verstärkt. Durch die Bewertung kippen die Bewerterschaltungen BWS in einen dem zu bewertenden Datum entsprechenden Zustand, wie allgemein bekannt. Dieser Vorgang wurde bereits bezüglich der ersten Ausführungsformen erläutert.

Wurde, wie im Beispiel angenommen, eine Wortleitung WL zum Auslesen der Daten aus Speicherzellen SZ angesteuert, deren zugeordnete Speicherzellen SZ mit den internen Bitleitungen BL verbunden sind, so weist nach dem Bewerten im Gut-Fall also jede interne Bitleitung BL das ausgelesene Datum (beispielsweise "log. 1", wie für die weitere Beschreibung angenommen) auf. Entsprechend weisen die internen Bitleitungen B̅L̅ ein dazu komplementäres Datum (im Beispiel: "log. 0") auf. Spätestens zu diesem Zeitpunkt wird die eine externe Bitleitung XB des externen Bitleitungspaares XB,X̅B̅, auf der im Gut-Fall eine log. 1 erwartet wird, auf log. 1 vorgeladen. Die jeweils andere externe Bitleitung X̅B̅ kann auf log. 0 vorgeladen werden. Dies ist jedoch nicht notwendig, wie bereits bezüglich der ersten Ausführungsformen erläutert. Nun werden die einen Paare von Trenntransistoren TT mittels des Dekoders DEC durchgeschaltet. Das erste Testsignal Test1 nimmt ebenfalls den Wert log. 1 an, während das zweite Testsignal Test2 den Wert log. 0 annimmt. Im Gut-Fall behält die eine, demzufolge die auf log. 1 vorgeladene, externe Biltleitung XB des externen Bitleitungspaares XB,X̅B̅, ähnlich wie bereits in EP-A 0 283 907 beschrieben, ihren durch Vorladen entstandenen Zustand bei. Im Fehlerfall (d.h. mindestens eine der internen Bitleitungen BL weist das Datum log. 0 auf) sinkt das Potential den einen ursprünglich auf log. 1 vorgeladenen externen Bitleitung XB um den bereits genannten Betrag Δ U_{ERROR} soweit ab, bis sich über die restlichen internen Bitleitungen BL, die den richtigen Wert log. 1 aufweisen, ein Gleichgewicht einstellt. Die externe Bewerterschaltung BWSext ist während dieses Vorganges deaktiviert. Eine Diskriminatoreinrichtung DISC erkennt dieses Absinken und gibt entsprechend ein Fehlersignal ab. Dieser Vorgang ist derselbe wie bereits bezüglich der ersten Ausführungsformen beschrieben. Auch die vorliegenden zweiten Ausführungsformen der Erfindung verhindern ein Kippen derjenigen internen Bewerterschaltung BWS, an deren zugeordneten Speicherzelle SZ oder an deren zugeordnetem internen Bitleitungspaar BL, B̅L̅ der Fehler auftrat, in einen Zustand, der (irrtümlicherweise) dem Zustand entspricht, der im Gut-Fall vorliegen würde. Während bei den ersten Ausführungsformen der Erfindung (vgl. die Figuren 1, 2) das kippen durch ein getrenntes Ansteuern der einen Trenntransistoren TT mittels der Schalttransistoren ST verhindert wird, wird das Kippen bei den zweiten Ausführungsformen nach den Figuren 3, 4 durch die weiteren Trenntransistoren TT1, TT2 zuverlässig verhindert. Im vorliegenden Fall verhindert dies der andere weitere Trenntransistor TT2, da er aufgrund seiner Ansteuerung mit dem zweiten Testsignal Test2 = log. 0 sperrt. Das Sperren des anderen weiteren Trenntransistors TT2 wiederum ist der Grund, weshalb es auch bei den zweiten Ausführungsformen nicht notwendig ist, die andere externe Bitleitung X̅B̅ auf log. 0 vorzuladen.

Von einer detaillierten Beschreibung von Funktion und Betriebsverfahren der zweiten Ausführungsformen für den Fall, daß Speicherzellen zu testen sind, die jeweils mit der anderen internen Bitleitung B̅L̅ verbunden sind, wird abgesehen, da der Fachmann leicht erkennt, daß oblige Ausführungen auch für diesen Fall sinngemäß gelten, wenn er die Nomenklatur entsprechend ändert (z.B. Ersetzen von "die eine interne Bitleitung BL" durch "die andere interne Bitleitung B̅L̅", "die eine externe Bitleitung XB" durch "die andere externe Bitleitung X̅B̅", "der eine Trenntransistor TT1 der weiteren Paare von Trenntransistoren TT1,TT2" durch "der andere Trenntransistor TT2 der weiteren Paare von Trenntransistoren TT1,TT2" und umgekehrt).

In dem Fall, in dem die zu testenden Speicherzellen SZ log. 0 enthalten sollen, wird, ebenso wie bereits bezüglich der ersten Ausführungsformen beschrieben, der Effekt ausgenutzt, daß sich bei jedem internen Bitleitungspaar BL,B̅L̅ auf derjenigen internen Bitleitung , die nicht mit der zu testenden jeweiligen Speicherzelle SZ verbunden ist, ein zum ausgelesenen und verstärkten Lesesignal komplementäres Signal, d.h. also im Gut-Fall eine log. 1 ausbildet. Demzufolge wird in diesem Fall die andere externe Bitleitung X̅B̅ auf log. 1. vorgeladen. Weiterhin nimmt das erste Testsignal Test1 den Wert log. 0 an, wodurch die einen weiteren Trenntransistoren TT1 sperren, was im Fehler-Fall das bereits beschriebene Kippen verhindert. Das zweite Testsignal Test2 weist den Wert log. 1 auf.

Anhand der vorhergehenden Ausführungen, einen Test auf log. 1 betreffend, kann nun der Fachmann selbst nachvollziehen, daß im Gut-Fall die andere externe Bitleitung X̅B̅ ihren Wert log. 1 beibehält und demzufolge die Diskriminatoreinrichtung kein Fehlersignal erzeugt und daß im Fehler-Fall die andere externe Bitleitung X̅B̅ potentialmäßig um den bereits beschriebenen Betrag ΔU_{ERROR} in Richtung log. 0 gezogen wird. Dies wiederum erkennt die Diskriminatoreinrichtung DISC und aktiviert entsprechend das Fehlersignal. Ein Kippen der betroffenen internen Bewerterschaltung BWS ist auch in diesem Fall zuverlässig ausgeschlossen. Wegen der Analogie zum bereits beschriebenen Testen auf log. 1 wird von einer ausführlichen Erläuterung abgesehen.

FIG 3 zeigt einer ersten Ausgestaltung der zweiten Ausführungsformen die vorteilhafte Anordnung der weiteren Paare von Trenntransistoren TT1,TT2 zwischen dem Speicherzellenfeld MEM und den einen Paaren von Trenntransistoren TT. Es ist jedoch in einer zweiten Ausgestaltung der zweiten Ausführungsformen ebenso vorteilhaft, wie in FIG 4 dargestellt, die weiteren Paare von Trenntransistoren TT1,TT2 zwischen den einen Paaren von Trenntransistoren TT und dem externen Bitleitungspaar XB,X̅B̅ anzuordnen.

Es ist weiterhin vorteilhaft, da platzsparend, für je einen Transistor eines weiteren Paares von Trenntransistoren TT1,TT2 und den damit verbundenen Transistor des einen Paares von Trenntransistoren TT ein gemeinsames Diffusionsgebiet D vorzusehen, das für beide Transistoren TT1 und TT bzw. TT2 und TT als Source- bzw. als Draingebiet wirkt. Dies ist in FIG 5 dargestellt.

Bei Realisierung der vorliegenden Erfindung, insbesondere bei Realisierung der zweiten Ausführungsformen, werden die Leitungen der Testsignale Test1, Test2 weitgehend parallel zu den Leitungen des externen Bitleitungspaares XB,X̅B̅ verlaufen. Dabei ist es vorteilhaft, die Leitungen der beiden Testsignale Test1, Test2 als abschirmende Leitungen bezüglich der Leitungen des externen Bitleitungspaares XB,X̅B̅ anzuordnen (FIG 4).

Ebenso wie bezüglich der Ausgestaltung nach FIG 2 gilt auch für die Ausgestaltung nach FIG 4 folgendes: die andere externe Bitleitung X̅B̅ (bzw. XB) des externen Bitleitungspaares XB,X̅B̅, deren Vorladen auf log. 0 gemäß den vorstehenden Ausführungen nicht notwendig ist, zu den genannten Testzwecken jedoch auf ein Potential Uₚ₀ vor, das um den halben Wert Δ U_{ERROR} unter dem Wert von log. 1 liegt, um den im Fehlerfall, wie bereits beschrieben, die eine auf log. 1 vorgeladene externe Bitleitung XB (bzw. X̅B̅ absinkt, und aktiviert die externe Bewerterschaltung BWSext, so wirkt diese selbst als Diskriminatoreinrichtung DISC (s. FIG 2,4,6) und kippt in eine Lage, die dem Fehlerfall entspricht, wodurch ihr Ausgang als Fehlersignal wirkt. Damit läßt sich auch bei den zweiten Ausführungsformen eine separate Diskriminatoreinrichtung DISC samt einer evtl. notwendigen Multiplexschaltung MUX einsparen. Dies ist in FIG 4 gezeigt.

## Patentansprüche

1. Integrierter Halbleiterspeicher
- mit in einem Speicherzellenfeld (MEM) matrixförmig angeordneten Speicherzellen (SZ), die über Wortleitungen (WL) und Paare von internen Bitleitungen (BL,B̅L̅) bildende interne Bitleitungen (BL,B̅L̅) ansteuerbar sind,
- mit einer internen Bewerterschaltung (BWS) je internem Bitleitungspaar (BL,B̅L̅),
- mit einem Paar von Trenntransistoren (TT) je internem Bitleitungspaar (BL,B̅L̅) zur elektrischen Trennung des internen Bitleitungspaares (BL,B̅L̅) von einem den internen Bitleitungen (BL,B̅L̅) gemeinsamen externen Bitleitungspaar (XB, X̅B̅),
- mit einem Bitleitungsdekoder (DEC) zur Ansteuerung der Paare von Trenntransistoren (TT),
- mit einer externen Bewerterschaltung (BWSext) und
- mit einer Diskriminatoreinrichtung (DISC) und einer Vorladeeinrichtung (PC), die mit dem externen Bitleitungspaar (XB, X̅B̅) verbunden sind,
**dadurch gekennzeichnet,**
daß die Bitleitungen (BL, B̅L̅) jedes Paares von internen Bitleitungen (BL, B̅L̅) getrennt voneinander ansteuerbar sind, wodurch die Bitleitungen (BL, B̅L̅) jedes Paares von internen Bitleitungen (BL, B̅L̅) getrennt voneinander mit dem externen Bitleitungspaar (XB, X̅B̅) verbindbar sind.

2. Integrierter Halbleiterspeicher nach Anspruch 1, **dadurch gekennzeichnet**, daß die getrennte Ansteuerung durch den Bitleitungsdekoder (DEC) in Abhängigkeit von einem Paar von Testsignalen (Test1,Test2) erfolgt.

3. Integrierter Halbleiterspeicher nach Anspruch 2, **dadurch gekennzeichnet,** daß die getrennte Ansteuerung je Paar von Trenntransistoren (TT) mittels eines in Serie zueinander geschalteten Paares von Schalttransistoren (ST) erfolgt, deren Sources gemeinsam mit einer Dekoderleitung (DEC_{BL}) verbunden sind, deren Drains mit den Gates der Trenntransistoren (TT) verbunden sind und deren Gates mit dem Paar von Testsignalen (Test1,Test2) verbunden sind.

4. Intergrierter Halbleiterspeicher nach Anspruch 1, bei dem die Transistoren jedes Paares von Trenntransistoren (TT) parallel zueinander ansteuerbar sind,
**dadurch gekennzeichnet,**
daß zur getrennten Ansteuerung der Bitleitungen (BL, B̅L̅) jedes Paares der internen Bitleitungen (BL, B̅L̅) je Paar von Trenntransistoren (TT) ein weiteres Paar von Trenntransistoren (TT1, TT2) vorgesehen ist, wobei jeder Trenntransistor (TT) mit einem der weiteren Trenntransistoren (TT1, TT2) in Serie geschaltet ist und daß bei dem weiteren Paar von Trenntransistoren (TT1, TT2) der eine Transistor (TT1) durch ein erstes Testsignal (Test1) gesteuert ist und der andere Transistor (TT2) durch ein zweites Testsignal (Test2) gesteuert ist.

5. Integrierter Halbleiterspeicher nach Anspruch 4, **dadurch gekennzeichnet**, daß das weitete Paar von Trenntransistoren (TT1,TT2) zwischen dem Speicherzellenfeld (MEM) und dem einen Paar von Trenntransistoren (TT) angeordnet ist.

6. Integrierter Halbleiterspeicher nach Anspruch 4, **dadurch gekennzeichnet,** daß das weitere Paar von Trenntransistoren (TT1,TT2) zwischen dem externen Bitleitungspaar (XB,X̅B̅) und dem einen Paar von Trenntransistoren (TT) angeordnet ist.

7. Integrierter Halbleiterspeicher nach einem der Ansprüche 4 bis 6, **dadurch gekennzeichnet,** daß für je einen Transistor des weiteren Paares von Trenntransistoren (TT1,TT2) und den damit verbundenen einen Transistor des einen Paares von Trenntransistoren (TT) ein gemeinsames Diffusionsgebiet (D) vorgesehen ist, das für beide Transistoren (TT1,TT; TT2,TT) als Source- bzw. als Draingebiet wirkt.

8. Integrierter Halbleiterspeicher nach einem der vorhergehenden Ansprüche, **dadurch gekennzeichnet**, daß Leiterbahnen, die die Testsignale (Test1, Test2) aufweisen, als abschirmende Leiterbahnen bezüglich der Leiterbahnen des externen Bitleitungspaares (XB,X̅B̅) angeordnet sind.

9. Integrierter Halbleiterspeicher nach einem der vorhergehenden Ansprüche, **dadurch gekennzeichnet**, daß im Testbetrieb die eine (XB;X̅B̅) der beiden Bitleitungen des externen Bitleitungspaares (XB,X̅B̅) auf log. 1 vorgeladen ist und daß die andere (X̅B̅;XB) der beiden Bitleitungen des externen Bitleitungspaares (XB,X̅B̅) auf ein Potential (Uₚ₀) vorgeladen ist, das um die Hälfte eines Betrages (ΔU_{ERROR}) unter dem Wert log. 1 liegt, um den im Fehlerfall die eine, auf log. 1 vorgeladene Bitleitung (XB;X̅B̅) des externen Bitleitungspaares (XB,X̅B̅) absinkt.

## Claims

1. Integrated semiconductor memory
- having memory cells (SZ) which are arranged in matrix form in a memory cell field (MEM) and can be triggered by means of word lines (WL) and internal bit lines (BL,B̅L̅), forming pairs of internal bit lines (BL,B̅L̅),
- having an internal weighting circuit (BWS) for each internal bit line pair (BL,B̅L̅),
- having a pair of separation transistors (TT) for each internal bit line pair (BL,B̅L̅) for electrical separation of the internal bit line pair (BL,B̅L̅) from an external bit line pair (XB,XB), shared by the internal bit lines (BL,B̅L̅),
- having a bit line decoder (DEC) for triggering the pairs of separation transistors (TT),
- having an external weighting circuit (BWSext) and
- having a discriminator device (DISC) and a precharging device (PC), which are connected to the external bit line pair (XB,X̅B̅),
**characterised**
in that the bit lines (BL,B̅L̅) of each pair of internal bit lines (BL,B̅L̅) can be triggered separately from each other, whereby the bit lines (BL,B̅L̅) of each pair of internal bit lines (BL,B̅L̅ ) are able to be connected separately from each other to the external bit line pair (XB,X̅B̅).

2. Integrated semiconductor memory according to Claim 1, characterised in that the separate triggering is performed by the bit line decoder (DEC) as a function of a pair of test signals (Test1,Test2).

3. Integrated semiconductor memory according to Claim 2, characterised in that the separate triggering for each pair of separation transistors (TT) is performed by means of a pair of switching transistors (ST) connected in series with each other, the sources of which are connected in common to a decoder line (DEC_{BL}), the drains of which are connected to the gates of the separation transistors (TT) and the gates of which are connected to the pair of test signals (Test1,Test2).

4. Integrated semiconductor memory according to Claim 1, in which the transistors of each pair of separation transistors (TT) are able to be triggered parallel to each other, characterised in that, for the separate triggering of the bit lines (BL,B̅L̅) of each pair of internal bit lines (BL, B̅L̅) for each pair of separation transistors (TT), a further pair of separation transistors (TT1,TT2) is provided, each separation transistor (TT) being connected in series with one of the further separation transistors (TT1,TT2) and in that in the further pair of separation transistors (TT1,TT2) the one transistor (TT1) is controlled by a first test signal (Test1) and the other transistor (TT2) is controlled by a second test signal (Test2).

5. Integrated semiconductor memory according to Claim 4, characterised in that the further pair of separation transistors (TT1,TT2) is arranged between the memory cell field (MEM) and the one pair of separation transistors (TT).

6. Integrated semiconductor memory according to Claim 4, characterised in that the further pair of separation transistors (TT1,TT2) is arranged between the external bit line pair (XB,X̅B̅) and the one pair of separation transistors (TT).

7. Integrated semiconductor memory according to one of Claims 4 to 6, characterised in that for each transistor of the further pair of separation transistors (TT1,TT2) and the one transistor connected therewith of the one pair of separation transistors (TT) there is provided a common diffusion zone (D), which acts as source zone and as drain zone, respectively, for both transistors (TT1,TT; TT2,TT).

8. Integrated semiconductor memory according to one of the preceding claims, characterised in that conductor tracks which have the test signals (Test1, Test2) are arranged as shielding conducting tracks with respect to the conductor tracks of the external bit line pair (XB,X̅B̅).

9. Integrated semiconductor memory according to one of the preceding claims, characterised in that, in test mode, the one bit line (XB;X̅B̅) of the two bit lines of the external bit line pair (XB,X̅B̅) is precharged to logical 1 and in that the other bit line (XB;X̅B̅) of the two bit lines of the external bit line pair (XB,X̅B̅) is precharged to a potential (Uₚ₀) which is lower than the value of logical 1 by half an amount (ΔU_{ERROR}) by which the one bit line (XB;X̅B̅) precharged to logical 1, of the external bit line pair (XB,X̅B̅) drops in the case of an error.

## Revendications

1. Mémoire intégrée à semiconducteurs comportant
- des cellules de mémoire (SZ) qui sont disposées en forme de matrice dans un champ de cellules de mémoire (MEM) et qui sont susceptibles d'être commandées par l'intermédiaire de lignes de mots (WL) et de lignes internes de bits (BL,B̅L̅), qui constituent des couples de lignes internes de bits (BL,B̅L̅),
- un circuit interne d'évaluation (BWS) pour chaque couple interne de lignes de bits (BL,B̅L̅),
- un couple de transistors de séparation (TT) par couple interne de lignes de bits (BL,B̅L̅), pour la séparation électrique des couples internes de lignes de bits (BL,B̅L̅) d'un couple externe de lignes de bits (XB,X̅B̅) qui est commun aux lignes internes de bits (BL,B̅L̅),
- un décodeur de lignes de bits (DEC) pour la commande du couple de transistors de séparation (TT),
- un circuit d'évaluation externe (BWSext) et
- un dispositif discriminateur (DISC) et un dispositif de pré-chargement (PC), qui sont reliés au couple externe de lignes de bits (XB,X̅B̅),
caractérisée en ce que
-les lignes de bits (BL,B̅L̅), de chaque couple de lignes internes de bits (BL,B̅L̅), sont susceptibles d'être commandées séparément les uns des autres, en sorte que les lignes de bits (BL,B̅L̅) de chaque couple de lignes internes de bits (BL,B̅L̅) sont susceptibles d'être reliées séparément les unes des autres au couple externe de lignes de bits (XB,X̅B̅).

2. Mémoire intégrée à semiconducteurs selon la revendication 1, caractérisée en ce que la commande séparée s'effectue par l'intermédiaire du décodeur de lignes de bits (DEC) en fonction d'un couple de signaux de test (Test1, Test2).

3. Mémoire intégrée à semiconducteurs selon la revendication 2, caractérisée en ce que la commande séparée de chaque couple de transistors de séparation (TT) s'effectue au moyen d'un couple de transistors de commutation (ST) qui sont reliés l'un à l'autre en série, dont les sources sont reliées en commun à une ligne de décodage (DEC_{BL}), dont les drains sont reliés aux grilles des transistors de séparation (TT) et dont les grilles sont reliées au couple de signaux de test (Test1, Test2).

4. Mémoire intégrée à semiconducteurs selon la revendication 1, dans laquelle les transistors de chaque couple de transistors de séparation (TT) sont susceptibles d'être commandés en parallèle les uns des autres, caractérisée en ce que,
il est prévu, pour la commande séparée des lignes de bits (BL,B̅L̅) de chaque couple de lignes internes de bits (BL,B̅L̅), par couple de transistors de séparation (TT), un second couple de transistors de séparation (TT1, TT2), chaque transistor de séparation (TT) étant relié en série avec un transistor du second couple de transistors de séparation (TT1, TT2), et en ce que, pour ledit second couple de transistors de séparation (TT1, TT2), le transistor (TT1) est commandé par un premier signal de test (Test1) et l'autre transistor (TT2) est commandé par un deuxième signal de test (Test2).

5. Mémoire intégrée à semiconducteurs selon la revendication 4, caractérisée en ce que le second couple de transistors de séparation (TT1, TT2) est disposé entre le champ de cellules de mémoire (MEM) et le premier couple de transistors de séparation (TT).

6. Mémoire intégrée à semiconducteurs selon la revendication 4, caractérisée en ce que le second couple de transistors de séparation (TT1, TT2) est disposé entre le couple externe de lignes de bits (XB, X̅B̅) et le premier couple de transistors de séparation (TT).

7. Mémoire intégrée à semiconducteurs selon l'une des revendications 4 à 6, caractérisée en ce que, pour chacun des transistors du second couple de transistors de séparation (TT1, TT2), et pour ledit transistor de chacun des couples de transistors de séparation (TT), qui lui est relié, il est prévu une zone de diffusion commune (D) qui agit, pour les deux transistors (TT1, TT; TT2, TT), comme zone de source ou comme zone de drain.

8. Mémoire intégrée à semiconducteurs selon l'une des revendications précédentes, caractérisée en ce que des pistes conductives, qui comportent les signaux de test (Test1, Test2), sont disposées comme pistes conductives de protection en ce qui concerne les pistes conductives du couple externe de lignes de bits (XB,X̅B̅).

9. Mémoire intégrée à semiconducteurs selon l'une des revendications précédentes, caractérisée en ce que, en opération de test, l'une (XB, X̅B̅) des deux lignes de bits du couple externe de lignes de bits (XB,X̅B̅) est préchargée par un 1 logique, et en ce que l'autre, (X̅B̅; XB), des deux lignes de bits du couple externe de lignes de bits (XB,X̅B̅) est préchargée au potentiel (Uₚ₀) qui se situe, en dessous de la valeur du 1 logique, de la moitié d'une quantité (ΔU_{ERROR}) pour laquelle chute, dans le cas d'un défaut, la ligne de bits (XB ; X̅B̅) du couple externe de lignes de bits (XB, X̅B̅) qui a été préchargée par un 1 logique.
